# EUROPEAN PATENT APPLICATION

(11) **EP 4 815 701 A1**
(43) Date of publication of application: **30.09.2026**
(21) Application number: 26166853.7
(22) Date of filing: 23.03.2026
(51) Int. Cl.: H10P 14/24, H10P 14/20

(54) **SILICON CARBIDE EPITAXIAL SUBSTRATE AND METHOD OF MANUFACTURING THE SAME**

(30) Priority: 25.03.2025 JP 2025050515
(71) Applicant: Proterial, Ltd., Tokyo 135-0061 (JP)
(72) Inventor: TANAKA, Kenya, Tokyo, 135-0061 (JP); MIURA, Tsuyoshi, Tokyo, 135-0061 (JP); OKUDA, Hiroyuki, Tokyo, 135-0061 (JP); HIROOKA, Taisuke, Tokyo, 135-0061 (JP)
(74) Representative: Wilson Gunn

(57) **Abstract**

To improve the reliability of a silicon carbide epitaxial substrate. A silicon carbide epitaxial substrate including a silicon carbide substrate and an epitaxial layer formed on an upper surface of the silicon carbide substrate is used. Here, a plurality of surface defects is provided on an upper surface of the epitaxial layer. The plurality of surface defects includes minute surface defects that are defects satisfying L < d/tanθ where a length of the surface defect in plan view is denoted as L, a thickness of the epitaxial layer is denoted as d, and an off-angle of the silicon carbide substrate is denoted as θ. In this case, a density of the minute surface defects is 100 counts/cm² or less.

## Description

### CROSS-REFERENCE TO RELATED APPLICATIONS

The disclosure of Japanese Patent Application No. 2025-050515 filed on March 25, 2025 including the specification, drawings and abstract is incorporated herein by reference in its entirety.

### BACKGROUND

The present disclosure relates to a silicon carbide epitaxial substrate and a method of manufacturing the same.

Silicon carbide (SiC) exhibits excellent thermal stability, chemical stability, mechanical strength, and radiation resistance. In addition, Silicon carbide has high breakdown voltage and high thermal conductivity compared to silicon (Si). According to a semiconductor device using silicon carbide, performance that is difficult to realize by a semiconductor device using an existing semiconductor material such as silicon can be realized. Therefore, silicon carbide is a promising candidate as a next-generation semiconductor material in various fields.

Japanese Patent Application Laid-open Publication No. 2022-151601 describes that a silicon carbide epitaxial substrate is manufactured by forming an epitaxial layer on an upper surface of a substrate made of silicon carbide (hereinafter, referred to as a silicon carbide substrate). Here, it is described that the density of linear surface defects generated on the upper surface of the epitaxial layer is reduced.

Applied Physics Vol. 82, No. 10, 846 describes the influence of dislocations present in a silicon carbide substrate on a semiconductor device using silicon carbide.

### SUMMARY

When an epitaxial layer is continuously formed on the upper surface of the silicon carbide substrate, the state of the inside of a growth chamber of a growth apparatus changes due to deposition of deposits caused by a raw material gas, or the like. The change of the state inside the growth chamber of the growth apparatus may affect the quality of a silicon carbide epitaxial substrate, and as a result, may affect the reliability of a semiconductor device manufactured using the silicon carbide epitaxial substrate.

In view of the above circumstances, an object of the present disclosure is to improve the reliability of a silicon carbide epitaxial substrate.

A silicon carbide epitaxial substrate in one embodiment includes a silicon carbide substrate and an epitaxial layer formed on an upper surface of the silicon carbide substrate. In this embodiment, a plurality of surface defects is formed on the upper surface of the epitaxial layer. The plurality of surface defects includes minute surface defects that are defects satisfying L < d/tanθ where a length of the surface defect in plan view is denoted as L, a thickness of the epitaxial layer is denoted as d, and an off-angle of the silicon carbide substrate is denoted as θ. A density of the minute surface defects is 100 counts/cm² or less.

A silicon carbide epitaxial substrate in one embodiment includes a silicon carbide substrate and an epitaxial layer formed on an upper surface of the silicon carbide substrate. In this embodiment, a plurality of surface defects and a plurality of threading screw dislocations are formed on the upper surface of the epitaxial layer. Among the plurality of surface defects, defects satisfying L < d/tanθ where a length of the surface defect in plan view is denoted as L, a thickness of the epitaxial layer is denoted as d, and an off-angle of the silicon carbide substrate is denoted as θ are referred to as minute surface defects. In a graph in which a horizontal axis represents a density of the threading screw dislocations on the upper surface of the epitaxial layer and a vertical axis represents a density of minute surface defects on the upper surface of the epitaxial layer, a slope of an approximate curve when linear fitting is performed using a plurality of pieces of data by the least squares method with an intercept of the vertical axis fixed at 0 is smaller than 0.05. The plurality of pieces of data is obtained by plotting, on the graph, measurement results of the density of the threading screw dislocations and the density of the minute surface defects in each of a plurality of regions when the upper surface of the epitaxial layer is divided into the plurality of regions.

A method of manufacturing a silicon carbide epitaxial substrate in one embodiment includes (a) a step of preparing a silicon carbide substrate, and (b) a step of forming an epitaxial layer on an upper surface of the silicon carbide substrate in a growth chamber of a deposition apparatus. In the step (b), a silicon-based gas and a carrier gas are supplied into the growth chamber through a first pipe, and a carbon-based gas and a carrier gas are supplied into the growth chamber through a second pipe. In the step (b), the epitaxial layer is continuously formed on the upper surfaces of 25 or more silicon carbide substrates at a deposition speed faster than 40 µm/h. A plurality of surface defects and a plurality of threading screw dislocations are formed on an upper surface of the epitaxial layer. The plurality of surface defects includes minute surface defects that are defects satisfying L < d/tanθ where a length of the surface defect in plan view is denoted as L, a thickness of the epitaxial layer is denoted as d, and an off-angle of the silicon carbide substrate is denoted as θ. In the step (b), a flow rate of the carrier gas in the first pipe and a flow rate of the carrier gas in the second pipe are adjusted so that a density of the minute surface defects becomes 100 counts/cm² or less.

According to one embodiment, the reliability of the silicon carbide epitaxial substrate can be improved.

### BRIEF DESCRIPTION OF THE DRAWINGS

FIG. 1 is a cross-sectional view illustrating a silicon carbide epitaxial substrate in a first embodiment.
FIG. 2 is a cross-sectional view illustrating a silicon carbide substrate in the first embodiment.
FIG. 3 is a schematic cross-sectional view illustrating two gas supply pipes in the first embodiment.
FIG. 4 is a graph illustrating a carrier concentration distribution in an upper surface of an epitaxial layer of Example 3.
FIG. 5 is a graph illustrating a carrier concentration distribution in an upper surface of an epitaxial layer of Comparative Example 1.
FIG. 6 is a graph illustrating a carrier concentration distribution in an upper surface of an epitaxial layer of Comparative Example 2.
FIG. 7 is a graph illustrating a carrier concentration distribution in an upper surface of an epitaxial layer of Comparative Example 2.
FIG. 8 is a graph illustrating a variation in carrier concentration of silicon carbide epitaxial substrate when deposition is continuously performed on a plurality of silicon carbide substrates in Example 3.
FIG. 9 is a graph illustrating a variation in carrier concentration of silicon carbide epitaxial substrate when deposition is continuously performed on a plurality of silicon carbide substrates in Comparative Example 1.
FIG. 10 is a graph illustrating a variation in carrier concentration of silicon carbide epitaxial substrate when deposition is continuously performed on a plurality of silicon carbide substrates in Comparative Example 2.
FIG. 11 is a differential interference optical microscopic image obtained in detection of minute surface defects.
FIG. 12 is an analysis image obtained in detection of threading screw dislocations.
FIG. 13 is a plan view illustrating a threading screw dislocation density distribution and a minute surface defect density distribution on the entire upper surface of a silicon carbide epitaxial substrate of Example 3.
FIG. 14 is a plan view illustrating a threading screw dislocation density distribution and a minute surface defect density distribution on the entire upper surface of a silicon carbide epitaxial substrate of Comparative Example 1.
FIG. 15 is a graph illustrating a relationship between a density of threading screw dislocations and a density of minute surface defects.

### DETAILED DESCRIPTION

In all drawings for describing embodiments, the same members are denoted by the same reference numerals in principle, and a repeated description will be omitted. Note that, in order to make a drawing intelligible, hatching may be attached even if it is a plan view.

The radial direction in the present specification is a direction along the diameter of a silicon carbide substrate.

### First Embodiment

Hereinafter, improving the reliability of a silicon carbide epitaxial substrate and reducing the manufacturing cost of the silicon carbide epitaxial substrate by devising the manufacturing conditions of an epitaxial layer formed on an upper surface of a silicon carbide substrate will be described.

### Room for Improvement

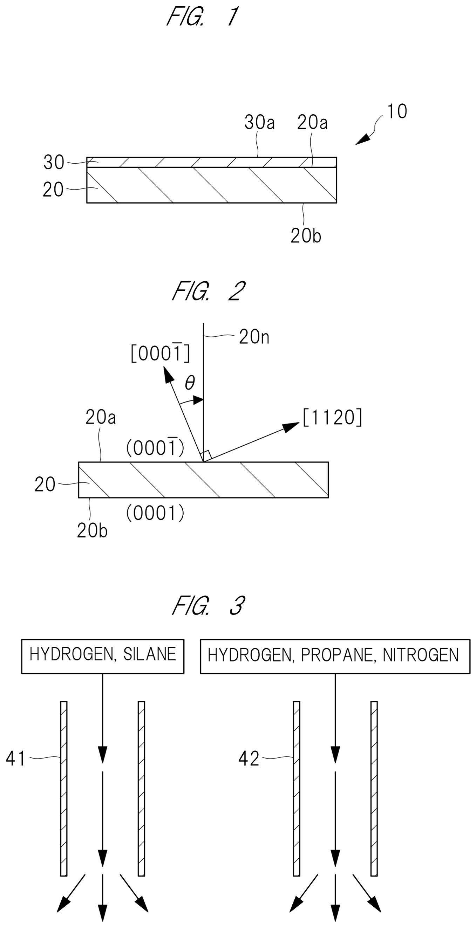

For the epitaxial layer formed on the upper surface of the silicon carbide substrate, the carrier concentration, the thickness of the epitaxial layer, and in-plane densities of various surface defects and dislocation-type defects are each required to fall within their respective desired ranges. The surface defect is a defect having irregularities on the upper surface of the epitaxial layer. The thickness refers to a longitudinal dimension in the plane of the drawing of FIG. 1 in the case of the epitaxial layer of FIG. 1. The dislocation-type defect refers to a defect without irregularities on the upper surface of the epitaxial layer and is detected by a photoluminescence method or the like. The desired range is determined by the design concept of a power device. Favorable silicon carbide epitaxial substrate conditions include a small carrier concentration, a small variation in thickness of the epitaxial layer, and a small density of various defects.

Here, as described in "Technical Problem" of SUMMARY, in the deposition of the epitaxial layer, when deposition is continuously performed, the state of the inside of a growth chamber of a deposition apparatus changes due to deposition of deposits caused by a raw material gas or the like. That is, the deposit adheres to the inner wall or the like of the growth chamber of the deposition apparatus. The variation in carrier concentration in the epitaxial layer may be increased depending on the mode and position where a deposit adheres. When the variation in carrier concentration in the epitaxial layer is increased, the reliability and yield of the silicon carbide epitaxial substrate are decreased.

From the viewpoint of improving the reliability of the silicon carbide epitaxial substrate, the variation in carrier concentration in the epitaxial layer is desirably small. In order to reduce the variation in carrier concentration, it is conceivable to maintain the state of the inside of the deposition apparatus by shortening the maintenance cycle for removing deposits in the deposition apparatus. The shortening of the maintenance cycle means reducing the number of silicon carbide substrates on which deposition is continuously performed in the deposition apparatus, and the operating rate of the deposition apparatus is low, so that the manufacturing cost of the silicon carbide epitaxial substrate increases.

Many threading dislocations, which are one of dislocation-type defects, are present in the silicon carbide substrate. The threading dislocations may be converted into surface defects having irregularities on the upper surface of the epitaxial layer during epitaxial deposition. The type of the threading dislocation includes a threading edge dislocation and a threading screw dislocation. These defects can cause various defects in semiconductor devices using silicon carbide, particularly silicon carbide power devices (Applied Physics Vol. 82, No. 10, 846). Threading screw dislocation (TSD) is a defect that occurs in an epitaxial layer on an upper surface of a silicon carbide substrate. The threading screw dislocation penetrates the epitaxial layer from the lower surface of the epitaxial layer toward the upper surface of the epitaxial layer. Therefore, the threading screw dislocation can be confirmed by observing the upper surface of the epitaxial layer.

When a thickness of the epitaxial layer is denoted as d, and the off-angle of the silicon carbide substrate is denoted as θ, the surface defects include linear surface defects whose length L is represented by L = d/tanθ. Such linear surface defects are also called carrot defects. Japanese Patent Application Laid-open Publication No. 2022-151601 discloses a method of reducing such linear surface defects.

For example, when the thickness of the epitaxial layer is 30 µm, the length L of the linear surface defect is about 430 µm. The present inventors have found that, in addition to such relatively large linear surface defects, linear surface defects having a smaller length L occur on the upper surface of the epitaxial layer. That is, the linear surface defects include linear surface defects represented by L = d/tanθ and smaller linear surface defects. In the present specification, in order to distinguish these linear surface defects from each other, among the linear surface defects, a defect satisfying L < d/tanθ is referred to as a minute surface defect. That is, the surface defects that occur on the upper surface of the epitaxial layer include minute surface defects that are defects satisfying L < d/tanθ.

The presence of minute surface defects can also cause the failure of various silicon carbide power devices. When the minute surface defects are increased on the upper surface of the epitaxial layer, the reliability and yield of the silicon carbide epitaxial substrate are decreased. Therefore, from the viewpoint of improving the reliability and yield of the silicon carbide epitaxial substrate, it is desirable to reduce the density of minute surface defects on the upper surface of the epitaxial layer.

When the deposition speed of the epitaxial layer is high, the manufacturing cost of the silicon carbide epitaxial substrate can be reduced. The deposition speed of the epitaxial layer described in the present specification is a rate at which a material constituting the epitaxial layer is deposited on the upper surface of the silicon carbide substrate in a deposition step of an epitaxial layer. The deposition speed of the epitaxial layer is represented by the thickness of the material deposited per unit time. The present inventors have found that minute surface defects are increased when the deposition speed of the epitaxial layer is increased.

As described above, as for the silicon carbide epitaxial substrate, there is an issue in that, when the epitaxial layer is continuously formed on the upper surfaces of the plurality of silicon carbide substrates, a change in the state of the inside of the growth chamber of the deposition apparatus due to deposition of deposits or the like caused by a raw material gas must be suppressed. In addition, there are problems of suppressing the variation in carrier concentration in the epitaxial layer and suppressing the occurrence of minute surface defects on the upper surface of the epitaxial layer. In contrast, when the number of substrates on which the epitaxial layer is continuously formed is reduced or the deposition speed is reduced, the manufacturing cost of the silicon carbide epitaxial substrate increases. Therefore, it is required to solve the problems of suppressing the variation in carrier concentration in the epitaxial layer and suppressing the occurrence of minute surface defects on the upper surface of the epitaxial layer while maintaining a high deposition speed without reducing the number of substrates on which deposition is continuously performed.

The present inventors have found that the mode and position where a deposit adheres in the growth chamber of the deposition apparatus are related to the supply conditions of the raw material gas described later. Therefore, the present inventors have devised a method of changing a mode and a position where a deposit adheres to the inner wall or the like in the growth chamber of the deposition apparatus. The present inventors have found that the variation in carrier concentration and the occurrence of minute surface defects described above are related to the supply conditions of the raw material gas described later. Therefore, the present inventors have devised a method of maintaining a state where the variation in carrier concentration is small without reducing the number of substrates on which deposition is continuously performed, and suppressing the occurrence of minute surface defects while maintaining a high deposition speed. Hereinafter, these devised methods will be described in detail.

Structure of Silicon Carbide Epitaxial Substrate

FIG. 1 is a cross-sectional view illustrating a silicon carbide epitaxial substrate 10 of a first embodiment. The silicon carbide epitaxial substrate 10 includes a silicon carbide substrate 20 and an epitaxial layer 30.

The silicon carbide substrate 20 includes a first surface 20a and a second surface 20b located on the opposite side of the first surface 20a, and the epitaxial layer 30 is located on the first surface 20a. The silicon carbide substrate 20 is made of single-crystalline silicon carbide. The polytype of the silicon carbide substrate 20 is preferably 4H. The size of the silicon carbide substrate 20 is not limited. From the viewpoint of mass productivity of semiconductor devices produced using the silicon carbide epitaxial substrate 10, the silicon carbide substrate 20 preferably has a diameter of 100 mm or more. The diameter of the SiC substrate having a size of 6 inches is preferably 145 mm or more, and more preferably 150 mm or more. The diameter of the SiC substrate having a size of 8 inches is preferably 195 mm or more, and more preferably 200 mm or more. The silicon carbide substrate 20 has a thickness based on the diameter according to the standard. For example, when the diameter is 100 mm or 150 mm, the thickness of the silicon carbide substrate 20 is 350 µm ± 25 µm or 500 µm ± 25 µm.

The first surface 20a of the silicon carbide substrate 20 used for the silicon carbide epitaxial substrate 10 is a Si plane. That is, silicon is exposed on the first surface 20a. The crystal orientation of the first surface 20a is (0001). Meanwhile, the second surface 20b is a C plane. That is, carbon is exposed on the second surface 20b. The crystal orientation of the second surface 20b is (000-1).

FIG. 2 is a cross-sectional view illustrating the silicon carbide substrate 20. The silicon carbide substrate 20 is preferably an off-axis substrate having an off-angle θ. Specifically, the first surface 20a or a normal line 20n of the first surface 20a is preferably inclined by θ from the [0001] direction to the [1120] direction. The off-angle θ is preferably 0.5° or more and 8° or less, and more preferably 0.5° or more and 5° or less.

The characteristics of the first surface 20a of the silicon carbide substrate 20 will be described in detail. The first surface 20a is preferably polished by a chemical mechanical polishing (CMP) method. Specifically, it is preferable that polishing is performed by a CMP method until the surface roughness Ra of the first surface 20a becomes 1 nm or less. More preferably, the surface roughness Ra of the first surface 20a is 0.2 nm or less. The surface roughness Ra can be measured, for example, by a white light interference microscope. The surface roughness Ra is, for example, a value obtained by measuring the first surface 20a at three positions with a length of 100 µm and determining an average of the measured values at the three positions. Although the surface roughness Ra is ideally 0 nm, the surface roughness Ra does not actually become 0 nm. Therefore, the lower limit value of a preferred range of the surface roughness Ra is larger than 0.

The basal plane dislocation (BPD) density on the first surface 20a is preferably 3000 counts/cm² or less. The BPD density is more preferably 2000 counts/cm² or less, and still more preferably 1000 counts/cm² or less. The BPD density can be measured, for example, by etching the first surface 20a by molten KOH (potassium hydroxide) and measuring the number of BPDs that appear as etch pits with an optical microscope. Similarly to the surface roughness Ra, the lower limit of a preferred range of the BPD density is larger than 0 counts/cm².

The epitaxial layer 30 is formed on the first surface 20a of the silicon carbide substrate 20 by an epitaxial growth method. The epitaxial layer 30 is made of single-crystalline silicon carbide. The thickness of the epitaxial layer 30 can be arbitrarily set according to performance required for a semiconductor device produced using the silicon carbide epitaxial substrate 10. For example, the thickness of the epitaxial layer 30 is 1 µm or more and 100 µm or less.

A plurality of linear surface defects is provided on an upper surface 30a of the epitaxial layer 30. The plurality of linear surface defects includes minute surface defects represented by L < d/tanθ. On the upper surface 30a of the epitaxial layer 30, the density of the minute surface defects is preferably less than 100 counts/cm². The density of the minute surface defects is more preferably 20 counts/cm² or less, and still more preferably 5 counts/cm² or less. A plurality of threading screw dislocations is formed in the epitaxial layer 30. On the upper surface 30a of the epitaxial layer 30, the density of the threading screw dislocations is preferably 400 counts/cm² or less.

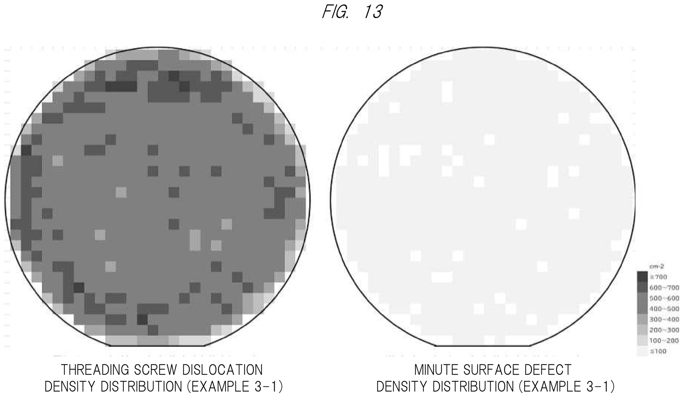

The minute surface defect has irregularities with respect to the upper surface 30a. When the upper surface 30a of the epitaxial layer 30 is viewed from a direction perpendicular to the upper surface, that is, in plan view, the minute surface defect has an elongated linear shape. The length L of the minute surface defect in the longitudinal direction in plan view depends on the thickness d of the epitaxial layer 30 and the off-angle θ of the silicon carbide substrate 20, and has a relationship of L < d/tanθ. Note that the term "plan view" means, for example, viewing the upper surface of the epitaxial layer of the silicon carbide substrate as illustrated in FIG. 13.

The minute surface defect density can be measured, for example, by a wafer inspection apparatus or a wafer review apparatus capable of acquiring a differential interference optical microscopic image. Such a wafer inspection apparatus and a wafer review apparatus can acquire the positions and number of regions of brightness changes that appear as a line-shaped pattern in the acquired differential interference optical microscopic image and calculate the density of the minute surface defects.

### Method of Manufacturing Silicon Carbide Epitaxial Substrate

Hereinafter, a method of manufacturing the silicon carbide epitaxial substrate 10 of the first embodiment will be described. First, the silicon carbide substrate 20 is prepared. The silicon carbide substrate 20 includes the first surface 20a having the crystal orientation and the off-angle described above. The first surface 20a is prepared by a CMP method so as to have a surface roughness Ra of 1 nm or less. The value of the surface roughness Ra is preferably small. For example, a commercially available silicon carbide substrate 20 may be obtained, and the first surface 20a may be further polished by a CMP method.

Next, the epitaxial layer 30 is formed on the first surface 20a of the silicon carbide substrate 20 by an epitaxial growth method. Here, the epitaxial layer 30 is formed using a chemical vapor deposition (CVD) method.

For example, the silicon carbide substrate 20 is introduced into a growth chamber of a deposition apparatus, and is disposed on a holder with the first surface 20a, which is the (0001) plane, facing upward. The silicon carbide substrate 20 is heated to a temperature of 1500°C or higher and 1800°C or lower, and a carrier gas, a gas serving as a carbon source, a gas serving as a silicon source, and a gas serving as a dopant are introduced into the growth chamber to form the epitaxial layer 30. For example, hydrogen (H₂) or the like can be used as the carrier gas. For the gas serving as a carbon source in the raw material gas, a carbon-based gas such as propane (C₃H₈) can be used. For the gas serving as a silicon source in the raw material gas, a silicon-based gas such as silane (SiH₄) can be used. For the gas serving as a dopant, nitrogen (N₂) or the like can be used. Before the epitaxial layer 30 is formed, only a carrier gas may be introduced into the growth chamber to clean the first surface 20a of the silicon carbide substrate 20.

These gases are supplied into the growth chamber through two gas supply pipes. FIG. 3 is a schematic cross-sectional view of two gas supply pipes in the first embodiment.

As illustrated in FIG. 3, as a plurality of gas supply pipes for supplying the raw material gas and the carrier gas into the growth chamber in the epitaxial growth, there are a silane pipe 41 for supplying a silane gas and a propane pipe 42 for supplying a propane gas. The silane gas as a raw material gas and the hydrogen gas as a carrier gas are supplied into the growth chamber through the silane pipe 41 (corresponding to the first pipe). Propane gas and nitrogen gas as raw material gases and hydrogen gas as a carrier gas are supplied into the growth chamber through the propane pipe 42 (corresponding to the second pipe).

A ratio C/Si, defined as carbon in the gas serving as a carbon source to silicon in the gas serving as a silicon source, is preferably 1 or more. Specifically, C/Si is preferably 1 or more and 1.6 or less.

The pressure in the growth chamber during growth of the epitaxial layer 30 is preferably 10 kPa or more and 50 kPa or less.

As described in the following Examples, in the method of manufacturing the silicon carbide epitaxial substrate 10 of the first embodiment, the epitaxial layer 30 is formed on the (0001) plane of the silicon carbide substrate 20. In the first embodiment, the flow rate of the carrier gas is adjusted in a deposition step of the epitaxial layer 30. Also in this case, in the deposition step of the epitaxial layer 30, the state inside the growth chamber of the deposition apparatus changes due to deposition of deposits caused by a raw material gas or the like. That is, the deposit adheres to the inner wall or the like of the growth chamber of the deposition apparatus. However, by adjusting the flow rate of the carrier gas as described above, the mode and position where a deposit adheres change. As a result, generation of minute surface defects on the upper surface 30a of the epitaxial layer 30 can be suppressed. When the epitaxial layer 30 is continuously formed on the plurality of silicon carbide substrates 20 in the deposition apparatus, the variation in carrier concentration in the epitaxial layer 30 can be suppressed by the adjustment. That is, by adjusting the flow rate of the carrier gas, it is possible to suppress the influence of deposition of deposits in the growth chamber on the reliability of the silicon carbide epitaxial substrate 10.

From the viewpoint of improving the reliability of the silicon carbide epitaxial substrate 10, a temperature difference between the central portion and the end portion of the first surface 20a of the silicon carbide substrate 20 in the deposition step of the epitaxial layer 30 is preferably 50°C or lower. The temperature difference is more preferably 20°C or lower, and still more preferably 10°C or lower.

### EXAMPLES

### Preparation of Sample

Hereinafter, the results of preparing the silicon carbide epitaxial substrate 10 using the method of manufacturing a silicon carbide epitaxial substrate of the first embodiment and measuring the carrier concentration and the density of minute surface defects will be described.

### Examples 1 to 3 and Comparative Examples 1 and 2

The silicon carbide substrate 20 having a diameter of 150 mm in which the first surface 20a is the (0001) plane and the off-angle θ is 4° was prepared. The first surface 20a was polished by a CMP method until the surface roughness Ra became 1 nm or less. Thereafter, the epitaxial layer 30 was formed on the first surface 20a of the silicon carbide substrate 20. The growth temperature was set to 1600°C, and the pressure in the growth chamber at the time of growth was set to 30 kPa. As illustrated in Table 1, C/Si in the raw material gas was set to 1.25. Hydrogen gas was used as a carrier gas, and propane gas and silane gas were used as raw material gases. Nitrogen was used as a dopant source.

Table 1 illustrates a flow rate ratio of hydrogen gas in the silane gas pipe between Examples 1 to 3 and Comparative Examples 1 and 2. The flow rate of hydrogen gas in the silane gas pipe was set so that the flow rate ratio of Comparative Example 2 was 120 when the flow rate ratio of Examples 1 to 3 and Comparative Example 1 was taken as 100.

Table 1 illustrates a flow rate ratio of hydrogen gas in the propane gas pipe between Examples 1 to 3 and Comparative Examples 1 and 2. The flow rate of hydrogen gas in the propane gas pipe was set so that the flow rate ratio of Example 1 was 65 and the flow rate ratio of Example 2 was 85 when the flow rate ratio of Comparative Examples 1 and 2 was taken as 100.

In Example 3, when the flow rate ratio of hydrogen gas in the propane gas pipe of Comparative Examples 1 and 2 was taken as 100, the flow rate ratio of hydrogen gas in the propane gas pipe was adjusted between 65 and 85. In Example 3, the carrier concentration on the upper surface 30a of the epitaxial layer 30 on which the deposition had been completed was measured, and the flow rate of the hydrogen gas in the propane gas pipe in the subsequent deposition step was adjusted according to the measurement result.

In Table 1, in each of Examples 1 to 3 and Comparative Examples 1 and 2, the temperature difference between the central portion and the end portion of the first surface 20a of the silicon carbide substrate 20 in Examples 1 to 3 is illustrated. In Examples 1 to 3, the temperature difference is set to be 50°C or lower. Specifically, in Examples 1 and 2, the temperature difference is 20°C. In Example 3, the temperature difference is 10 to 40°C. The temperature difference is more desirably 10°C or lower. In Comparative Examples 1 and 2, the temperature difference is considered to be larger than 50°C but is not constant, and thus, a specific numerical value of the temperature difference is not described in Table 1.

In Examples 1 and 2 and Comparative Example 1, the epitaxial layer 30 was formed only on one silicon carbide substrate 20. In Example 3, the epitaxial layer 30 was continuously formed on 28 silicon carbide substrates 20. In Comparative Example 2, the epitaxial layer 30 was continuously formed on 15 silicon carbide substrates 20. The expression "epitaxial layer is continuously formed" described in the present specification means that a step of forming the epitaxial layer 30 on the plurality of silicon carbide substrates 20 is performed without performing maintenance in a growth chamber of a deposition apparatus. In other words, the expression "epitaxial layer is continuously formed" means that a step of forming the epitaxial layer 30 on the plurality of silicon carbide substrates 20 is performed without releasing the vacuum state in a growth chamber of a deposition apparatus.

The deposition speed of the epitaxial layer 30 in each of Examples 1 to 3 was set to 48 µm/h, and the deposition speed of the epitaxial layer 30 in Comparative Example 1 and Comparative Example 2 were set to 45 µm/h and 43 µm/h, respectively. As described above, in Examples 1 to 3, the deposition speed of the epitaxial layer 30 was set to be higher than 40 µm/h.

**[Table 1]**

| | Example 1 | Example 2 | Example 3 | Comparative Example 1 | Comparative Example 2 |
|---|---|---|---|---|---|
| C/Si ratio | 1.25 | 1.25 | 1.25 | 1.25 | 1.25 |
| Flow rate ratio of hydrogen gas in silane pipe | 100 | 100 | 100 | 100 | 120 |
| Flow rate ratio of hydrogen gas in propane pipe | 85 | 65 | 65~85 | 100 | 100 |
| In-plane temperature difference | 20 | 20 | 10~40 | - | - |
| Number of substrates on which dislocation is continuously performed (sheets) | 1 | 1 | 28 | 1 | 15 |
| Dislocation speed (um/h) | 48 | 48 | 48 | 45 | 43 |
| Variation in carrier concentration | OK | OK | OK | NG | NG |
| Minute surface defect | OK | OK | OK | NG | OK |

Table 2 illustrates analysis results for each of Example 3-1, Example 3-2, Example 3-3, and Comparative Example 1-1. In Example 3-1, Example 3-2, and Example 3-3, separate silicon carbide epitaxial substrates 10 arbitrarily selected from the silicon carbide epitaxial substrates 10 produced under the same conditions as in Example 3 described above were analyzed. In Comparative Example 1-1, the silicon carbide epitaxial substrate 10 arbitrarily selected from the silicon carbide epitaxial substrates 10 produced under the same conditions as in Comparative Example 1 described above was analyzed.

The threading screw dislocations in the silicon carbide epitaxial substrate 10 were detected for each of Example 3-1, Example 3-2, Example 3-3, and Comparative Example 1-1. From the detection results, as illustrated in Table 2, the average value (average number) of threading screw dislocations in the upper surface 30a of the epitaxial layer 30 was calculated.

From the detection results of minute surface defects on the upper surface 30a of the epitaxial layer 30, as illustrated in Table 2, the average value of minute surface defects in the upper surface 30a of the epitaxial layer 30 was calculated.

As illustrated in Table 2, for each of Example 3-1, Example 3-2, Example 3-3, and Comparative Example 1-1, the slope of the approximate curve representing the relationship between the density of threading screw dislocations and the density of minute surface defects was calculated.

**[Table 2]**

| | In-plane average value of threading screw dislocation densities (counts/cm²) | In-plane average value of minute surface defects (counts/cm²) | Slope of approximate curve |
|---|---|---|---|
| Example 3-1 | 506 | 13 | 0.024 |
| Example 3-2 | 423 | 2 | 0.004 |
| Example 3-3 | 191 | 8 | 0.037 |
| Comparative Example 1-1 | 156 | 277 | 1.744 |

### Measurement

The deposition speed illustrated in Table 1 was calculated from the thickness of the epitaxial layer after deposition and the deposition time. The thickness of the epitaxial layer was measured using a non-contact film thickness measuring device. The thickness of the epitaxial layer was measured using a film thickness measuring device "UTS-2000" manufactured by JASCO Corporation.

The carrier concentration illustrated in Table 1 was measured at a plurality of positions in an X direction and a Y direction in the upper surface 30a of the epitaxial layer 30 by a capacitance-voltage (CV) method. The measurement of the carrier concentration was performed using a CV measuring instrument "CVmap92A" manufactured by Four Dimensions, Inc. The X direction and the Y direction are along the upper surface 30a of the epitaxial layer 30 and are orthogonal to each other in plan view. The X direction is a direction of the orientation flat (a direction along the [1120] direction), and the Y direction is a direction orthogonal to the orientation flat. The maximum carrier concentration is denoted as Max, the minimum carrier concentration is denoted as Min, and the average of measurement results of carrier concentrations at all of the plurality of positions is denoted as Ave. among measurement results of carrier concentrations at a plurality of positions on the upper surface 30a of one silicon carbide epitaxial substrate 10. At this time, the variation in carrier concentration in the upper surface 30a of the epitaxial layer 30 is expressed by formula: 0.5 × (Max - Min) /Ave. In the determination of the variation in carrier concentration illustrated in Table 1, a case where the variation in carrier concentration is 20% or less was determined as OK, and a case where the variation in carrier concentration is more than 20% was determined as NG.

The detection of minute surface defects illustrated in Table 1 was performed by performing surface observation of the epitaxial layer 30 using a differential interference lens of a confocal microscope and analyzing the obtained differential interference optical microscopic image by dividing the image into regions (chips) of 5 mm × 5 mm. This surface observation was performed using a defect inspection apparatus "SICA" (registered trademark) manufactured by Lasertec Corporation. Since the minute surface defect has irregularities with respect to the surface, the brightness appears different in the image as compared with an ideal crystal region that is flat. The average value of minute surface defects illustrated in Table 1 is calculated as the number per unit area by averaging the number of minute surface defects in each of the plurality of regions. In the determination of minute surface defects in Table 1, a case where the average value of minute surface defects is less than 100 counts/cm² was determined as OK, and a case where the average value of minute surface defects is 100 counts/cm² or more was determined as NG. The in-plane average value of minute surface defects illustrated in Table 2 is calculated as the number per unit area by averaging the number of minute surface defects in each of the plurality of regions.

The detection of threading screw dislocations of the silicon carbide epitaxial substrate 10 illustrated in Table 1 was performed by measuring a reflected image of the [0008] plane (0008 reflected image) using X-ray topography and analyzing the obtained image by dividing the image into regions of 5 mm × 5 mm. The measurement of the 0008 reflected image was performed using a topograph measurement system "XRTMicron" (registered trademark) manufactured by Rigaku Corporation. The in-plane average value of threading screw dislocation densities illustrated in Table 2 is obtained by calculating the number of threading screw dislocations in each of the plurality of regions as the number per unit area and calculating the average value thereof.

The slope of the approximate curve illustrated in Table 2 is obtained by graphing the density of threading screw dislocations of the silicon carbide epitaxial substrate 10 on the horizontal axis and the density of minute surface defects in the upper surface 30a of the silicon carbide epitaxial substrate 10 on the vertical axis, and calculating the slope of the approximate curve when linear fitting is performed by the least squares method with an intercept of the vertical axis fixed at 0.

### Results and Discussion

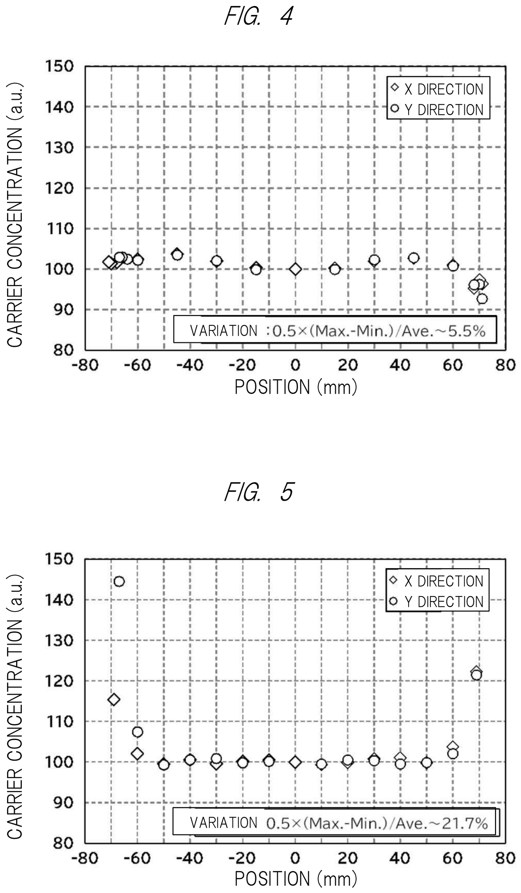

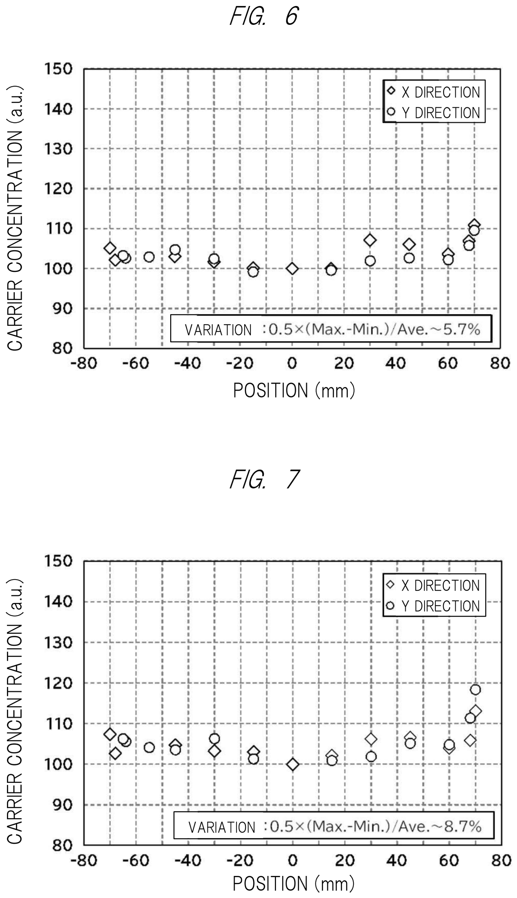

FIGS. 4, 5, 6, and 7 illustrate carrier concentration distributions in the upper surface 30a of the epitaxial layer 30. FIG. 4 is a graph illustrating a carrier concentration at each position in the upper surface 30a of the epitaxial layer 30 formed under the same conditions as in Example 1. FIG. 5 is a graph illustrating a carrier concentration at each position in the upper surface 30a of the epitaxial layer 30 formed under the same conditions as in Comparative Example 1. FIG. 6 is a graph illustrating a carrier concentration at each position in the upper surface 30a of the epitaxial layer 30 constituting the first silicon carbide epitaxial substrate 10 among 15 silicon carbide epitaxial substrates 10 on which deposition was continuously performed under the same conditions as in Comparative Example 2. FIG. 7 is a graph illustrating a carrier concentration at each position in the upper surface 30a of the epitaxial layer 30 constituting the fifth silicon carbide epitaxial substrate 10 among 15 silicon carbide epitaxial substrates 10 on which deposition was continuously performed under the same conditions as in Comparative Example 2.

In FIGS. 4, 5, 6, and 7, the horizontal axis represents the position of the upper surface 30a of the silicon carbide epitaxial substrate 10 in the radial direction, and the vertical axis represents the carrier concentration in the upper surface 30a of the epitaxial layer 30.

The silicon carbide epitaxial substrate 10 is a disk-shaped semiconductor substrate. The diameter of the silicon carbide substrate 20 is 150 mm. That is, the silicon carbide epitaxial substrate 10 has a diameter of 6 inches. The numerical values on the horizontal axis in FIGS. 4, 5, 6, and 7 indicate the radial distance from the center of the upper surface 30a of the circular silicon carbide epitaxial substrate 10. In FIGS. 4, 5, 6, and 7, diamond-shaped plots represent carrier concentrations measured at a plurality of measurement points aligned in the X direction that is the radial direction of the upper surface 30a of the silicon carbide epitaxial substrate 10. In FIGS. 4, 5, 6, and 7, circular plots represent carrier concentrations measured at a plurality of measurement points aligned in the Y direction that is the radial direction of the upper surface 30a of the silicon carbide epitaxial substrate 10. In FIGS. 4, 5, 6, and 7, assuming that the carrier concentration at the center of the upper surface 30a of the silicon carbide epitaxial substrate 10 is 100, the relative carrier concentrations at other positions are described.

As illustrated in FIG. 4, as a result of calculating the variation in carrier concentration in the upper surface 30a of the epitaxial layer 30 formed under the same conditions as in Example 1 by the formula: 0.5 × (Max - Min)/Ave., the variation in carrier concentration was 5.5%. Meanwhile, as illustrated in FIG. 5, the variation in carrier concentration in the upper surface 30a of the epitaxial layer 30 formed under the same conditions as in Comparative Example 1 was 21.7%.

As illustrated in FIGS. 6 and 7, the variation in carrier concentration in the upper surface 30a of the epitaxial layer 30 continuously formed under the same conditions as in Comparative Example 2 was 5.7% in the first silicon carbide epitaxial substrate 10, and 8.7% in the fifth silicon carbide epitaxial substrate 10. Although no graph is illustrated for the sixth and subsequent silicon carbide epitaxial substrates 10, as illustrated in FIGS. 6 and 7, as the number of substrates on which deposition is continuously performed increases, the variation in carrier concentration also increases accordingly. As a result, although no graph is illustrated here, the variation in carrier concentration in the upper surface 30a of the epitaxial layer 30 constituting the 15th silicon carbide epitaxial substrate 10 exceeded 20%.

As described above, as illustrated in Table 1, the determination of Example 1 was OK, and the determination of Example 2 and Example 3 was similarly OK. On the other hand, the determination of Comparative Example 1 and Comparative Example 2 was NG. As described above, in Examples 1 to 3, the variation in carrier concentration on the upper surface 30a of the epitaxial layer 30 can be suppressed as compared with Comparative Example 1 and Comparative Example 2. Even when deposition is continuously performed on 25 or more silicon carbide substrates 20 as in Example 3, the variations in carrier concentration can be suppressed.

Here, the plurality of silicon carbide substrates 20 may be conveyed in a set of 25 sheets in a container called a cassette or a carrier. As a result, it is conceivable that 25 silicon carbide substrates 20 are handled as one lot and deposition is continuously performed on the 25 silicon carbide substrates 20 in a process such as deposition of the epitaxial layer 30. Actually, deposition may be continuously performed on about 100 to 150 silicon carbide substrates 20. Since 25 silicon carbide substrates 20 are used as one set and then are subjected to a process, such as deposition, when the number of silicon carbide substrates 20 on which deposition is continuously performed is less than 25, the manufacturing cost of the silicon carbide epitaxial substrate 10 increases. Therefore, continuous deposition on 25 or more silicon carbide substrates 20 contributes to improvement of efficiency of the manufacturing process of the silicon carbide epitaxial substrate 10. In other words, the manufacturing cost of the silicon carbide epitaxial substrate 10 can be reduced.

The silicon carbide substrate 20 may be subjected to a process, such as deposition, with 10 sheets as one set. Therefore, continuous deposition on 10 or more silicon carbide substrates 20 contributes to improvement of efficiency of the manufacturing process of the silicon carbide epitaxial substrate 10.

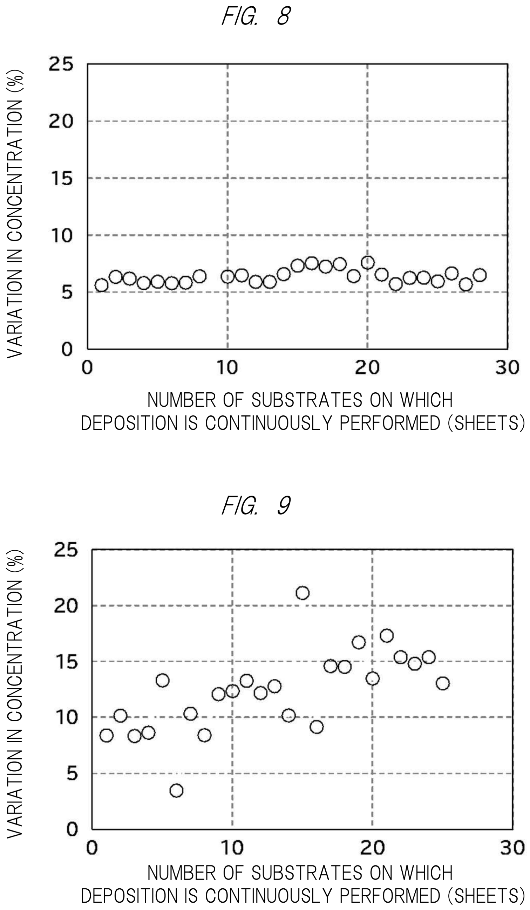

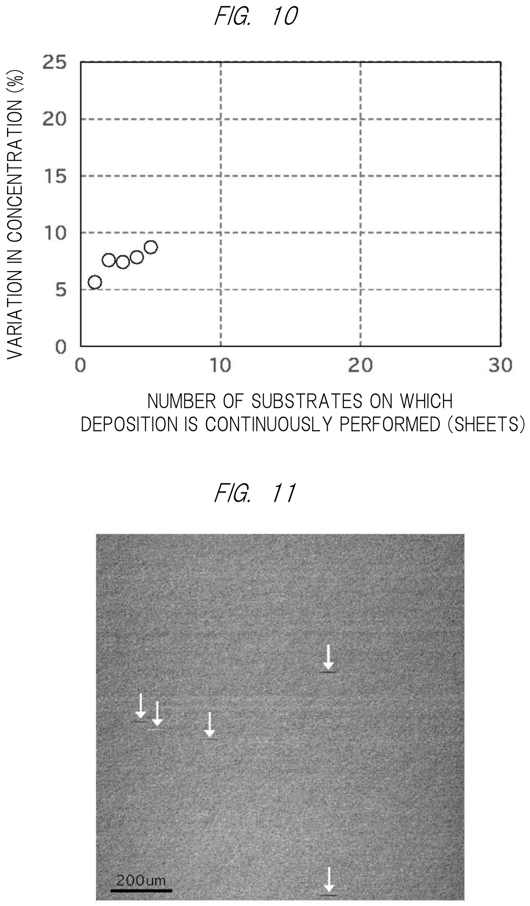

FIGS. 8, 9, and 10 illustrate a variation in carrier concentration in the upper surface 30a of each epitaxial layer 30 when the epitaxial layer 30 is continuously formed on the upper surfaces of the plurality of silicon carbide substrates 20. FIG. 8 is a graph illustrating a carrier concentration in the upper surface 30a of each epitaxial layer 30 when 28 epitaxial layers 30 are continuously formed under the same conditions as in Example 3. FIG. 9 is a graph illustrating a carrier concentration in the upper surface 30a of each epitaxial layer 30 when 25 epitaxial layers 30 are continuously formed under the same conditions as in Comparative Example 1. FIG. 10 is a graph illustrating a carrier concentration in the upper surface 30a of each epitaxial layer 30 when 5 epitaxial layers 30 are continuously formed under the same conditions as in Comparative Example 2.

The horizontal axis in FIGS. 8, 9, and 10 indicates the number of silicon carbide substrates 20 when deposition is continuously performed on the upper surface of the silicon carbide substrate 20. The vertical axis in FIGS. 8, 9, and 10 indicates the variation in carrier concentration. The value on the vertical axis is a numerical value representing variation calculated by formula: 0.5 × (Max - Min)/Ave.

As illustrated in FIG. 8, when the deposition is performed under the same conditions as in Example 3, the variation in carrier concentration is small, and a change of the variation in carrier concentration is small even when the deposition is continuously performed.

On the other hand, as illustrated in FIG. 9, when the deposition is performed under the same conditions as in Comparative Example 1, the variation in carrier concentration increases as the number of silicon carbide substrates 20 on which deposition is continuously performed increases. For example, in the epitaxial layer 30 which is formed as the 15th film, the variation in carrier concentration exceeds 20%. From the graph of FIG. 9, it can be predicted that the variation in carrier concentration exceeds 20% when the number of substrates on which deposition is continuously performed exceeds about 30.

As illustrated in FIG. 10, when the deposition is performed under the same conditions as in Comparative Example 2, the variation in carrier concentration increases as the number of silicon carbide substrates 20 on which deposition is continuously performed increases. From the graph of FIG. 10, it can be predicted that the variation in carrier concentration exceeds 20% when the number of substrates on which deposition is continuously performed exceeds about 20.

As described above, in Example 3, the variation in carrier concentration on the upper surface 30a of the epitaxial layer 30 can be suppressed as compared with Comparative Example 1 and Comparative Example 2. Even when deposition is continuously performed on 25 or more silicon carbide substrates 20 as in Example 3, the variations in carrier concentration can be suppressed. Therefore, the manufacturing cost of the silicon carbide epitaxial substrate 10 can be reduced, and the variation in carrier concentration can be suppressed.

FIG. 11 illustrates a differential interference optical microscopic image acquired in detection of minute surface defects. As indicated by arrows in FIG. 11, the minute surface defects appear linearly on the upper surface 30a of the epitaxial layer 30. Here, light is emitted from the upper side of FIG. 11. In a portion linearly recessed from the upper surface 30a, a shadow portion can be confirmed as a black line. A portion linearly protruding from the upper surface 30a can be confirmed as a white line at the portion hit by the light.

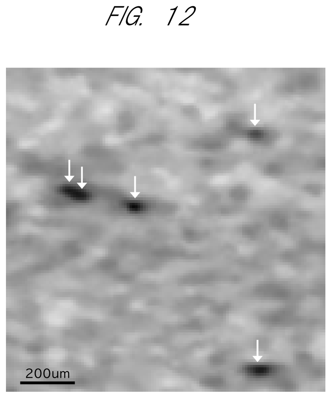

FIG. 12 illustrates an analysis image (0008 reflected image) obtained using X-ray topography in detection of a threading screw dislocation. As indicated by arrows in FIG. 12, the threading screw dislocations appear as black spots on the upper surface 30a of the epitaxial layer 30. FIGS. 11 and 12 are images obtained by observing substantially the same portion of the same silicon carbide epitaxial substrate 10. By comparing FIGS. 11 and 12, it is conceivable that a portion where the minute surface defect occurs and a portion where the threading screw dislocation occurs correspond to each other.

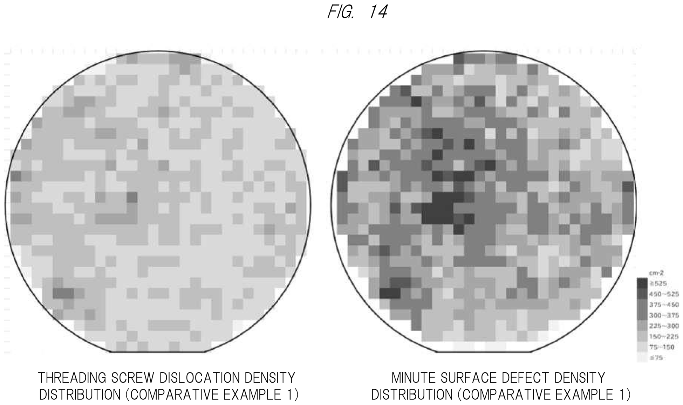

FIGS. 13 and 14 are plan views illustrating a threading screw dislocation density distribution and a minute surface defect density distribution on the entire upper surface 30a of the silicon carbide epitaxial substrate 10. On the left side of FIG. 13, the threading screw dislocation density distribution on the entire upper surface 30a of the silicon carbide epitaxial substrate 10 produced under the same conditions as in Example 3 is illustrated. On the right side of FIG. 13, the minute surface defect density distribution on the entire upper surface 30a of the silicon carbide epitaxial substrate 10 produced under the same conditions as in Example 3 is illustrated. On the left side of FIG. 14, the threading screw dislocation density distribution on the entire upper surface 30a of the silicon carbide epitaxial substrate 10 produced under the same conditions as in Comparative Example 1 is illustrated. On the right side of FIG. 14, the minute surface defect density distribution on the entire upper surface 30a of the silicon carbide epitaxial substrate 10 produced under the same conditions as in Comparative Example 1 is illustrated.

In FIGS. 13 and 14, the densities of threading screw dislocations and minute surface defects in the upper surface 30a of the silicon carbide epitaxial substrate 10 are illustrated in different brightness in each divided region of 5 mm × 5 mm. As illustrated in FIGS. 13 and 14, when the manufacturing conditions of Comparative Example 1 were applied, the silicon carbide epitaxial substrate 10 having a lower density of threading screw dislocations as compared with a case where the manufacturing conditions of Example 3 were applied was used. As described above, when the manufacturing conditions of Example 3 are applied, although the silicon carbide epitaxial substrate 10 having a relatively high density of threading screw dislocations is used, the density of minute surface defects on the entire upper surface 30a of the silicon carbide epitaxial substrate 10 can be reduced as compared with a case where the manufacturing conditions of Comparative Example 1 are applied.

As illustrated in FIG. 14 and Table 2, the silicon carbide epitaxial substrate 10 produced under the same conditions as in Comparative Example 1 seems to have high quality when attention is paid only to the threading screw dislocation density distribution. However, when the silicon carbide epitaxial substrate 10 is produced under the same conditions as in Comparative Example 1, minute surface defects are likely to occur on the upper surface 30a of the epitaxial layer 30. From the viewpoint of improving the reliability and yield of the silicon carbide epitaxial substrate 10, it is important to suppress the density of minute surface defects as in the silicon carbide epitaxial substrate 10 produced under the same conditions as in Example 3.

As illustrated on the right side of FIG. 13, it can be seen that the density of minute surface defects is 100 counts/cm² or less in any region on the upper surface 30a of the silicon carbide epitaxial substrate 10. From such measurement results, as illustrated in Table 1, for Examples 1 to 3 and Comparative Example 2, the determination of the minute surface defect was OK. On the other hand, in Comparative Example 1, the determination of the minute surface defect was NG.

As described above, in Examples 1 to 3, the occurrence of minute surface defects on the upper surface 30a of the epitaxial layer 30 can be suppressed as compared with Comparative Example 1. In the first embodiment, by adjusting the flow rate of the hydrogen gas, it is possible to suppress the occurrence of minute surface defects while maintaining the deposition speed faster than 40 µm/h. Thus, the manufacturing cost of the silicon carbide epitaxial substrate 10 can be reduced, and the variation in carrier concentration can be suppressed.

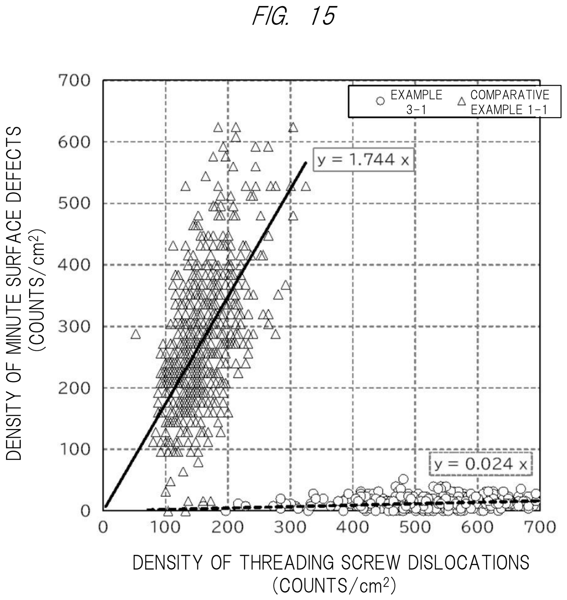

FIG. 15 is a graph illustrating a relationship between a density of threading screw dislocations and a density of minute surface defects. The horizontal axis in FIG. 15 indicates the density of threading screw dislocations in the silicon carbide epitaxial substrate 10. The vertical axis in FIG. 15 indicates the density of minute surface defects on the upper surface 30a of the epitaxial layer 30. Each of the plurality of triangular plots illustrated in FIG. 15 represents the density of threading screw dislocations and the density of minute surface defects measured in each region when the upper surface 30a of the silicon carbide epitaxial substrate 10 of Comparative Example 1-1 is divided into a plurality of regions of 5 mm × 5 mm. Each of the plurality of circular plots illustrated in FIG. 15 represents the density of threading screw dislocations and the density of minute surface defects measured in each region when the upper surface 30a of the silicon carbide epitaxial substrate 10 of Example 3-1 is divided into a plurality of regions of 5 mm × 5 mm.

In FIG. 15, an approximate curve when linear fitting is performed using a plurality of pieces of data, which are a plurality of measurement results of Comparative Example 1-1, by the least squares method is indicated by a solid line. That is, the graph illustrated in FIG. 15 is created using the plurality of pieces of data. The intercept on the vertical axis of the approximate curve indicated by the solid line is 0 (counts/cm²). In FIG. 15, an approximate curve when linear fitting is performed using a plurality of pieces of data, which is a plurality of measurement results of Example 3-1, by the least squares method is indicated by a broken line. The intercept on the vertical axis of the approximate curve indicated by the broken line is 0 (counts/cm²). The plurality of pieces of data is obtained by plotting, on the graph, measurement results of the density of threading screw dislocations and the density of minute surface defects in each of a plurality of regions on the upper surface 30a of the silicon carbide epitaxial substrate 10.

A large value of the slope of the approximate curve means that there is a high probability that the threading screw dislocation of the substrate converts into a minute surface defect. From the viewpoint of improving the reliability and yield of the silicon carbide epitaxial substrate 10, the slope of the approximate curve is desirably less than 0.05. As illustrated in FIG. 15, the slope of the approximate curve of Comparative Example 1-1 is represented by y = 1.744x. The slope of the approximate curve of Example 3-1 is represented by y = 0.024x. That is, as illustrated in Table 2, the slope of the approximate curve of Comparative Example 1-1 is 1.744, and the slope of the approximate curve of Example 3-1 is 0.024. In the silicon carbide epitaxial substrate 10 of Example 3-1, the density of minute surface defects on the upper surface 30a of the epitaxial layer 30 is suppressed to be small.

As described above, in Example 3-1, the occurrence of minute surface defects on the upper surface 30a of the epitaxial layer 30 can be suppressed as compared with Comparative Example 1-1. In the first embodiment, by adjusting the flow rate of the hydrogen gas, it is possible to suppress the occurrence of minute surface defects while maintaining a relatively high deposition speed of 40 µm/h. Thus, the manufacturing cost of the silicon carbide epitaxial substrate 10 can be reduced, and the variation in carrier concentration can be suppressed.

In the first embodiment, when the flow rate ratio of Comparative Examples 1 and 2 is taken as 100, the flow rate ratio of hydrogen gas in the propane gas pipe is adjusted between 65 and 85. By adjusting the gas amount in this manner, it is possible to suppress the occurrence of minute surface defects and the variation in carrier concentration on the upper surface 30a of the epitaxial layer 30 while maintaining the deposition speed faster than 40 µm/h. Therefore, the reliability and yield of the silicon carbide epitaxial substrate 10 can be improved while reducing the manufacturing cost of the silicon carbide epitaxial substrate 10. Even when deposition is continuously performed on 25 or more silicon carbide substrates 20, the variations in carrier concentration on the upper surface 30a of the epitaxial layer 30 can be suppressed. That is, while the manufacturing cost of the silicon carbide epitaxial substrate 10 is reduced, the variation in carrier concentration can be suppressed.

Although the invention made by the present inventors has been specifically described above based on the embodiments, it goes without saying that the present invention is not limited to the above embodiments and can be modified without departing from the gist thereof.

For example, another epitaxial layer may be formed between the silicon carbide substrate and the epitaxial layer described above. In the case, the epitaxial layer described in the present specification as being formed on the upper surface of the silicon carbide substrate is interpreted as being formed on the silicon carbide substrate.

## Claims

1. A silicon carbide epitaxial substrate comprising:
a silicon carbide substrate; and
an epitaxial layer formed on an upper surface of the silicon carbide substrate,
wherein a plurality of surface defects is provided on an upper surface of the epitaxial layer,
wherein the plurality of surface defects includes minute surface defects that are defects satisfying L < d/tanθ where a length of the surface defect in plan view is denoted as L, a thickness of the epitaxial layer is denoted as d, and an off-angle of the silicon carbide substrate is denoted as θ, and
wherein a density of the minute surface defects is 100 counts/cm² or less.

2. The silicon carbide epitaxial substrate according to claim 1,
wherein the density of the minute surface defects is 20 counts/cm² or less.

3. The silicon carbide epitaxial substrate according to claim 1,
wherein the density of the minute surface defects is 5 counts/cm² or less.

4. The silicon carbide epitaxial substrate according to claim 1,
wherein when the upper surface of the epitaxial layer is divided into a plurality of regions, a variation in carrier concentration in the upper surface of the epitaxial layer is represented by formula: 0.5 × (Max - Min)/Ave., where a maximum value of the carrier concentration in the plurality of regions is denoted as Max, a minimum value of the carrier concentration in the plurality of regions is denoted as Min, and an average value of carrier concentrations in the plurality of regions is denoted as Ave., and
wherein the variation in carrier concentration is 20% or less.

5. The silicon carbide epitaxial substrate according to claim 4,
wherein the variation in carrier concentration is 10% or less.

6. A silicon carbide epitaxial substrate comprising:
a silicon carbide substrate; and
an epitaxial layer formed on an upper surface of the silicon carbide substrate,
wherein a plurality of surface defects and a plurality of threading screw dislocations are provided on an upper surface of the epitaxial layer,
wherein the plurality of surface defects includes minute surface defects that are defects satisfying L < d/tanθ where a length of the surface defect in plan view is denoted as L, a thickness of the epitaxial layer is denoted as d, and an off-angle of the silicon carbide substrate is denoted as θ,
wherein, in a graph created using a plurality of pieces of data with a horizontal axis representing a density of the threading screw dislocations and a vertical axis representing a density of the minute surface defects,
a slope of an approximate curve when linear fitting is performed by the least squares method with an intercept of the vertical axis fixed at 0 is smaller than 0.05, and
wherein the plurality of pieces of data is obtained by plotting, on the graph, measurement results of the density of the threading screw dislocations and the density of the minute surface defects in each of a plurality of regions when the upper surface of the epitaxial layer is divided into the plurality of regions.

7. A method of manufacturing a silicon carbide epitaxial substrate, comprising the steps of:
(a) preparing a silicon carbide substrate; and
(b) forming an epitaxial layer on an upper surface of the silicon carbide substrate in a growth chamber of a deposition apparatus,
wherein, in the step (b), a silicon-based gas and a carrier gas are supplied into the growth chamber through a first pipe, and a carbon-based gas and a carrier gas are supplied into the growth chamber through a second pipe,
wherein, in the step (b), the epitaxial layer is continuously formed on the upper surfaces of 25 or more silicon carbide substrates at a deposition speed faster than 40 µm/h,
wherein a plurality of surface defects and a plurality of threading screw dislocations are provided on an upper surface of the epitaxial layer,
wherein the plurality of surface defects includes minute surface defects that are defects satisfying L < d/tanθ where a length of the surface defect in plan view is denoted as L, a thickness of the epitaxial layer is denoted as d, and an off-angle of the silicon carbide substrate is denoted as θ, and
wherein, in the step (b), a flow rate of the carrier gas in the first pipe and a flow rate of the carrier gas in the second pipe are adjusted so that a density of the minute surface defects becomes 100 counts/cm² or less.

8. The method of manufacturing a silicon carbide epitaxial substrate according to claim 7,
wherein, in the step (b), in a graph created using a plurality of pieces of data with a horizontal axis representing a density of the threading screw dislocations and a vertical axis representing a density of the minute surface defects, the flow rate of the carrier gas in the first pipe and the flow rate of the carrier gas in the second pipe are adjusted so that a slope of an approximate curve when linear fitting is performed by the least squares method with an intercept of the vertical axis fixed at 0 is smaller than 0.05, and
wherein the plurality of pieces of data is obtained by plotting, on the graph, measurement results of the density of the threading screw dislocations and the density of the minute surface defects in each of a plurality of regions when the upper surface of the epitaxial layer is divided into the plurality of regions.

9. The method of manufacturing a silicon carbide epitaxial substrate according to claim 7,
wherein the carrier gas is hydrogen gas.

10. The method of manufacturing a silicon carbide epitaxial substrate according to claim 7,
wherein, when the upper surface of the epitaxial layer is divided into a plurality of regions, a variation in carrier concentration in the upper surface of the epitaxial layer is represented by formula: 0.5 × (Max - Min)/Ave., where a maximum value of the carrier concentration in the plurality of regions is denoted as Max, a minimum value of the carrier concentration in the plurality of regions is denoted as Min, and an average value of carrier concentrations in the plurality of regions is denoted as Ave., and
wherein, in the step (b), the flow rate of the carrier gas in the first pipe and the flow rate of the carrier gas in the second pipe are adjusted so that the variation in carrier concentration becomes 20% or less.

11. The method of manufacturing a silicon carbide epitaxial substrate according to claim 10,
wherein, in the step (b), the epitaxial layer is continuously formed on the upper surfaces of 10 or more of the silicon carbide substrates, and
wherein, in the step (b), the flow rate of the carrier gas in the first pipe and the flow rate of the carrier gas in the second pipe are adjusted so that the variation in carrier concentration becomes 10% or less.

12. The method of manufacturing a silicon carbide epitaxial substrate according to claim 10,
wherein, the carrier gas is hydrogen gas.
